(19) **Europäisches Patentamt**

**European Patent Office**

**Office européen des brevets**

(11) **EP 0 909 030 B1**

(12) **EUROPEAN PATENT SPECIFICATION**

(45) Date of publication and mention
of the grant of the patent:
**25.02.2004   Bulletin 2004/09**

(51) Int Cl.⁷: $H03K\ 3/0232$, $H03K\ 3/355$

(21) Application number: **97830506.8**

(22) Date of filing: **10.10.1997**

(54) **Integrated device for use in a monostable circuit**

In einer monostabilen Schaltung verwendbare integrierte Vorrichtung

Dispositif intégré utilisable dans un circuit monostable

(84) Designated Contracting States:
**DE FR GB IT**

(43) Date of publication of application:
**14.04.1999   Bulletin 1999/15**

(73) Proprietor: **STMicroelectronics S.r.l.**
**20041 Agrate Brianza (Milano) (IT)**

(72) Inventors:
• **Genova, Angelo**
**93010 Delia (Caltanisetta) (IT)**

• **Gariboldi, Roberto**
**20084 Lacchiarella (Milano) (IT)**
• **Cantone, Giuseppe**
**96100 Siracusa (IT)**

(74) Representative: **Pezzoli, Ennio et al**
**Jacobacci & Perani S.p.A.**
**Via Senato, 8**
**20121 Milano (IT)**

(56) References cited:
**US-A- 5 627 488**

## Description

The present invention relates to an integrated device for use in a monostable circuit, and in particular to an integrated device according to the preamble of the first claim.

Monostable circuits are commonly used in many different applications, for example in oscillators, in control devices within switching systems, as delay generators, and in general to produce a signal with rectangular waveform of specified duration. A monostable circuit exhibits a single stable state in which it generates an output signal of specified value. In response to a control signal (trigger), the circuit is carried into a non-stable state in which the output signal switches to a different value; the circuit is maintained in the non-stable state for a predetermined period of time, after which it returns to the stable state.

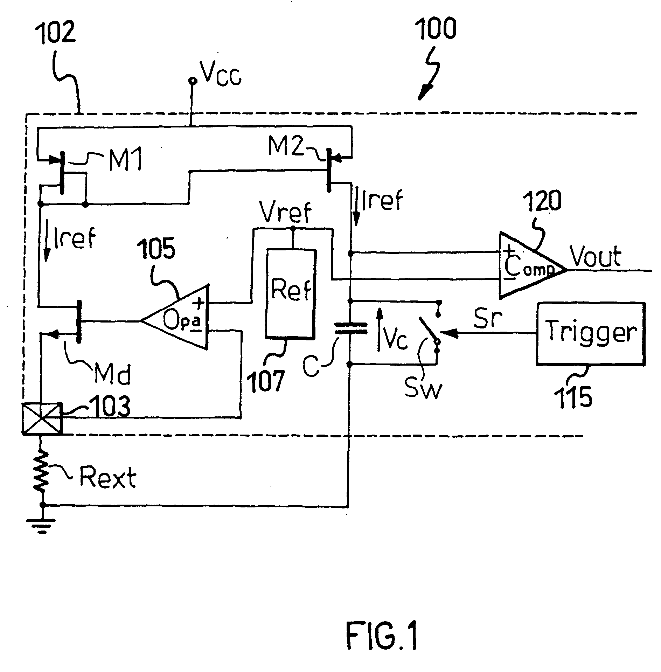

As illustrated in Fig.1, a particular type of known monostable circuit 100 includes a device 102 made in integrated form in a single chip of semiconductor material, to which is linked an external resistor Rext (or other equivalent circuit means) which makes it possible to programme the duration of the non-stable state of the circuit 100. In particular, the external resistor Rext (which typically has a resistance of the order of a few tens of kΩ) has a first terminal linked to a programming terminal 103 of the integrated device 102 (typically consisting of an external pin) and a second terminal linked to an external reference terminal (earth).

Provided inside the integrated device 102 is an operational amplifier (OpA) 105 which has a non-inverting input terminal (+) linked to a block (Ref) 107 which generates a reference voltage Vref (with respect to earth) and an inverting input terminal (-) linked to the programming pin 103. An output terminal of the operational amplifier 105 is linked to a gate terminal of a metal oxide silicon type field-effect transistor (MOSFET or simply MOS) Md (N-channel) having a source terminal linked to the programming pin 103 and a drain terminal linked to a drain terminal of an MOS transistor (P-channel) M1. The transistor M1 has a gate terminal linked to its own drain terminal and a source terminal linked to the positive terminal of an external power supply Vcc (whose negative terminal is connected to the earth terminal). The integrated device 102 includes a further MOS transistor (P-channel) M2 having a gate terminal and a source terminal which are linked, respectively, to the gate terminal and to the source terminal of the transistor M1. A drain terminal of the transistor M2 is linked to the first terminal of a capacitor C (or other equivalent circuit means), whose second terminal is linked to the earth terminal. Connected in parallel with the capacitor C is a switch SW, which is controlled by a suitable signal Sr generated by a block (Trigger) 115; alternatively, other equivalent circuit means are provided for switching the circuit 100 over to the non-stable state. The integrated device 102 furthermore includes a comparator (Comp) 120 having a non-inverting input terminal (+) and an inverting input terminal (-) which are linked, respectively, to the first terminal of the capacitor C and to the block 107 in such a way as to receive as input a voltage, respectively Vc and Vref (or vice versa). The comparator 120, typically made with an operational amplifier and exhibiting an ideally infinite input resistance, has an output terminal from which a signal Vout is extracted.

The reference voltage Vref is applied, via the operational amplifier 105 which operates as an impedance separator (buffer), to the programming pin 103; therefore, the external resistor Rext is traversed by a reference current Iref=vref/Rext (the values of the electrical quantities are indicated hereafter with the same symbols as are used to identify the corresponding components in the figures), the value of which can be programmed by varying the resistance of the external resistor Rext. The reference current Iref passes through the transistor Md (diode-connected) and is sent, via the current mirror formed by the transistors M1 and M2, to the capacitor C and the switch SW (regarding the input resistance of the comparator 120 as infinite).

In the stable state of the circuit 100, the switch SW is open and the capacitor C is charged in such a way that the voltage Vc is greater than the reference voltage Vref, so that the output signal Vout assumes a specified stable value. If the switch SW is closed (in response to a pulse of the control signal Sr) the voltage at the non-inverting input terminal of the comparator 120 is carried to a zero value (while the capacitor C discharges to the earth terminal), so that the output signal Vout switches to a different non-stable value. Once the pulse of the control signal Sr has ended, the switch SW is opened, so that the capacitor C begins to charge up via the reference current Iref. When the voltage Vc has reached the value of the reference voltage Vref, the output signal Vout returns to the stable value.

A drawback of the integrated device 102 described above consists in the fact that the latter requires the reference voltage Vref to be extremely accurate; for this purpose, complex and expensive filtering solutions are generally provided for reducing the effects of noise on the reference voltage Vref.

The integrated device 102 is also sensitive to noise present on the supply voltage Vcc, which must be similarly filtered out. Indeed, it should be noted that if there is a variation in the supply voltage Vcc, the voltage between the drain terminal and the source terminal of the transistor M2 will vary by the same amount (the voltage Vc at the terminals of the capacitor C being unable to vary instantaneously), so that there is a corresponding variation in the reference current Iref via which the capacitor C is charged; to minimize the error in the duration of the non-stable state of the circuit 100, a capacitor C with a very high capacitance, for example of the order of 10pF, and consequently occupying appreciable space in the semiconductor chip, is generally used.

Finally, the accuracy of the duration of the non-stable state is impaired by the off-set voltage of the operational amplifier 105 which operates as a buffer, this modifying the value of the voltage at the terminals of the external resistor Rext and hence the value of the reference current Iref.

US-A-5627488 discloses a delay circuit comprising a resistor and a capacitor and whose delay time is the product of the resistance of the resistor and the capacitance of the capacitor.

The purpose of the present invention is to overcome the aforesaid drawbacks. To achieve this purpose there is proposed an integrated device as described in the first claim.

Further characteristics and advantages of the integrated device according to the present invention will emerge from the following description of various preferred embodiments thereof, given by way of nonlimiting illustration, with reference to the appended figures in which:

Fig.1 illustrates a known monostable circuit;
Fig.2a is a basic block diagram of a monostable circuit which includes an example of an integrated device;
Fig.2b shows a qualitative timing diagram of the variation in a few electrical quantities of the circuit of Fig.2a;
Fig.3 illustrates a monostable circuit which includes an embodiment of the integrated device of the present invention.

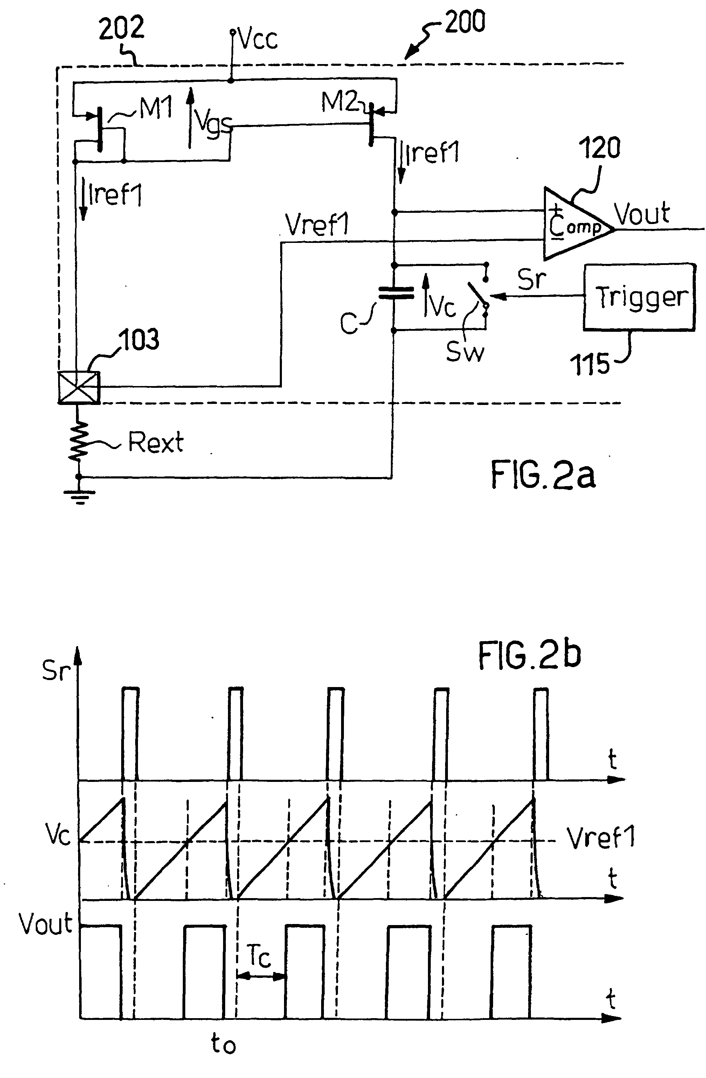

With reference in particular to Fig.2a (elements already shown in Fig.1, which was described earlier, are identified by the same reference numerals or symbols), a monostable circuit 200 which includes a device 202 made in integrated form as a semiconductor chip is shown. In the integrated device 202, the programming pin 103 (to which the external resistor Rext is connected) is linked directly to the inverting input terminal of the comparator 120, in such a way as to apply as input a reference voltage Vref1 equal to the voltage at the terminals of the external resistor Rext; in general, a voltage correlated with the voltage at the terminals, respectively, of the capacitor C and of the external resistor Rext is applied to the non-inverting and inverting input terminals of the comparator 120. The programming pin 103 is furthermore linked directly also to the drain terminal and to the gate terminal of the transistor M1, i.e. to the first branch of the current mirror M1,M2 (whose second branch is linked to the capacitor C); alternatively, other equivalent circuit means are used which are capable of sending a current Irefl which passes through the external resistor Rext to the capacitor C when the switch SW is open (regarding the input resistance of the comparator 120 as infinite).

To explain the operation of the circuit 200 reference is made to the qualitative timing diagram of Fig.

2b which illustrates the variation over time (t) in the control signal Sr, in the voltage Vc at the terminals of the capacitor C and in the output signal VOut. Consider an initial instant to at which the circuit 200 is in a stable state, with the switch SW open (signal Sr at low value) and the capacitor C charged so that the voltage Vc at its terminals is greater than the reference voltage Vref1; in this situation the output signal Vout assumes a stable value, for example high. Suppose now that the control signal Sr switches over for a short period to a high value, in such a way as to apply a control pulse to the switch SW; similar considerations apply for other equivalent wave forms of the control signal Sr. The switch SW is thus closed, so that the voltage at the non-inverting input terminal of the comparator 120 is carried to a zero value (while the capacity C discharges to the earth terminal); in this situation the output signal Vout switches over to a low non-stable value. Once the control pulse of the signal Sr has ended, the switch SW is opened, so that the capacitor C begins to charge up via the reference current Iref1. When the voltage at the terminals of the capacitor C has reached the value of the reference voltage Vref1, the output signal Vout returns to the high stable value.

It should be noted that the reference voltage Vref1 has a value equal to the supply voltage Vcc minus the voltage Vgs present between the gate terminal and the source terminal of the transistors M1 and M2:

$$Vref1 = Vcc - Vgs.$$

This value is constant, but not known a priori, since it depends on the supply voltage and on the physical structure of the transistors M1,M2 and hence on the process for fabricating the integrated device 202. Consequently, the reference current Irefl through the external resistor Rext also has a constant value (not known) given by:

$$Iref1 = \frac{Vref1}{Rext} = \frac{Vcc - Vgs}{Rext}$$

To determine the duration Tc of the non-stable state of the circuit 200 in which the output signal is maintained at the low value (neglecting the duration of the control pulse of the signal Sr), consider that from the general definition of current I=dQ/dV and capacitance C=Q/V, it follows that (C being constant):

$$I = \frac{dQ}{dt} = \frac{dCV}{dt} = C\frac{dV}{dt}$$

i.e.:

$$dV = \frac{I}{C}\,dt$$

Integrating both sides of this equation we have:

$$\int dv = \int \frac{I}{C}\, dt$$

from which, assuming the current I to be constant and the initial time and initial voltage to be zero, we obtain:

$$V = \frac{I}{C}\, t$$

In the case in question, the duration Tc of the non-stable state of the circuit 200, during which the capacitor C is charged via the constant current Iref1 from a zero initial voltage to the reference voltage Vref1, is equal to:

$$Tc = \frac{Vref1 \cdot C}{Iref1} = (Vcc\text{-}Vgs)\, \frac{Rext}{Vcc\text{-}Vgs}\, C = Rext \cdot C$$

The duration Tc of the non-stable state of the circuit 200 has thus a value which depends only on the resistance of the external resistor Rext and on the capacitance of the capacitor C, and is independent of any reference quantity (voltage or current).

The integrated device 202 described above does not require any block for the generation of a reference voltage and consequently does not use any buffer to apply the reference voltage to the external resistor Rext; therefore, it is extremely simple and occupies little space within the semiconductor chip. Furthermore, this structure is very accurate and less sensitive to noise.

With the solution described above it is possible to link in parallel with one and the same external resistor several integrated devices. Suppose there to be n (with n≥2) mutually identical integrated devices 202, each of which must be linked to an external resistor Rext having one and the same value of resistance (in such a way as to obtain one and the same reference current Iref1). In such a case it is possible to link the programming pin 103 of all the integrated devices 202 to the earth terminal via a single external resistor having a resistance of value Rext/n, in such a way that in each integrated device 202 there is the same reference current:

$$\frac{1}{n} \cdot \frac{Vref1}{\dfrac{Rext}{n}} = \frac{Vref1}{Rext} = Iref1$$

It should be noted that each integrated device 202 exhibits an impedance of high value (given by the transistor M1) at its own programming pin 103; therefore, the imbalances in the distribution of the current in the various integrated devices, due to constructional differences, are fairly well contained. In this way it is possible to reduce the number of external components while maintaining a satisfactory level of accuracy. On the contrary, this solution cannot be applied to the known integrated devices since they exhibit an extremely low impedance (given by the buffer 105 of Fig.1) at their programming pins, so that even slight constructional differences produce large imbalances in the distribution of current; with an unacceptable impairment of accuracy.

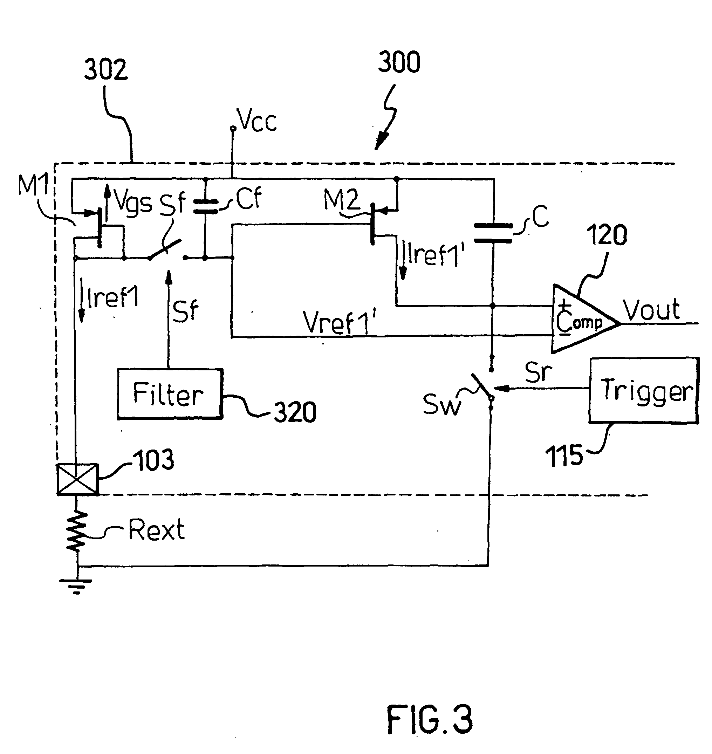

In an embodiment of the present invention, as illustrated in Fig.3 (elements already shown in Fig.2a are identified by the same reference numerals or symbols), a monostable circuit 300 includes an integrated device 302 wherein is provided a filtering switch Sf linked between a first node common to the programming pin 103, to the drain terminal and to the gate terminal of the transistor M1 and a second node common to the inverting input terminal of the comparator 120 and to the gate terminal of the transistor M2. The switch Sf is controlled by means of a suitable filtering signal Sf generated by a block (Filter) 320. A filtering capacitor Cf (or other equivalent circuit means) is moreover connected between the gate terminal and the source terminal of the transistor M2. In this case, the capacitor C is preferably linked between the non-inverting input terminal of the comparator 120 and the power terminal Vcc; alternatively, the capacitor C is linked to the earth terminal, as in the embodiment of the present invention illustrated in Fig.2a.

The switch Sf is normally kept closed, so that in the stable condition of the circuit 300 (switch SW open) the capacitor Cf is charged to the voltage Vgs between the gate terminal and the source terminal of the transistors M1 and M2. During the non-stable state of the circuit 300, the switch Sf is open, so that the capacitor Cf maintains the voltage between the gate terminal and the source terminal of the transistor M2 at the same value Vgs, irrespective of any noise due for example to capacitive couplings of the programming pin 103, which modify the value of the voltage between the gate terminal and the source terminal of the transistor M1. In this way, the inverting input of the comparator 120 is applied a filtered reference voltage Vref1' and the capacitor C is charged by a filtered reference current Iref1' which have a substantially constant value. Preferably, the filtering signal Sf keeps the switch Sf open for a filtering time interval whose start coincides with the switching of the control signal Sr (i.e. with the switching of the circuit 300 to the non-stable state) and with a duration at least equal to the duration Tc of the non-stable state of the circuit 300.

It should be noted that this result is obtained by filtering both the reference voltage Vref1 and the reference current Iref1 with a single filtering capacitor Cf. An analogous solution applied to the known integrated device described initially would in contrast require two filtering capacitors (with corresponding switches). With reference to Fig.1, a filtering capacitor, linked in a similar manner to the capacitor Cf described above, is used to filter the reference current Iref, as it maintains the voltage between the gate terminal and the source terminal of the transistor M2 constant. On the other hand, the reference block 107 is linked, via a further switch (controlled by the filtering signal), to the inverting input of the comparator 120 and to the first terminal of a further filtering capacitor, the second terminal of which is linked to the earth terminal, so as to maintain the reference voltage Vref applied to the comparator 120 constant.

Returning to Fig.3, the fact that the capacitor C is linked to the power terminal Vcc (and not to the earth terminal) renders the monostable circuit 300 immune also to noise present on the supply voltage Vcc; similar considerations apply in the case in which this solution is applied to the integrated device illustrated in Fig.2a. Thus, if during the capacitor C charging phase there is a variation in the supply voltage Vcc, the voltage at the drain terminal and at the gate terminal of the _transistor M2 will vary by the same amount (the voltage at the terminals of the capacitors, C and Cf respectively, being unable to vary instantaneously). In this way, the filtered reference voltage Vref1' remains steady (the voltage between the gate terminal and the source terminal of the transistor M2 being unchanged); furthermore, the filtered reference current Irefl' also remains steady, the voltage between the drain terminal and the source terminal of the transistor M2 being unchanged. It should be noted that this solution is not directly applicable to the known integrated device described in Fig.1, since if the supply voltage varies while the switch corresponding to the capacitor for filtering the reference voltage Vref is closed, this disturbance is transmitted to the reference block, rendering the use of the reference voltage Vref in other circuit blocks of the integrated device extremely problematic.

The structure described above is extremely accurate and makes it possible to use a capacitor C with limited capacitance, for example of the order of a few pF, and which occupies little space within the semiconductor chip.

Obviously a person skilled in the art will be able to introduce numerous modifications and variations to the integrated device described above, for the purpose of satisfying contingent and specific requirements, all nevertheless contained within the scope of protection of the invention, as defined by the following claims.

**Claims**

1. Integrated device (202) for use in a monostable circuit (200), the integrated device (202) having a programming terminal (103) able to be linked to resistive means (Rext) so as to programme the duration (Tc) of a non-stable state of the circuit (200) and comprising:

    a comparator (120) having a first (+) and a second (-) input terminal and an output terminal for generating an output signal (Vout) of the circuit (200), the programming terminal (103) being linked to the second input terminal (-) of the comparator (120) so as to apply thereto a voltage (Vref1) correlated with the voltage on the resistive means (Rext),
    capacitive means (C) linked to the first input terminal (+) of the comparator (120) so as to apply thereto a voltage (Vc) correlated with the voltage on the capacitive means (C),
    control means (SW,115) linked to the first input terminal (+) of the comparator (120) so as to switch the circuit (200) to the non-stable state, a current mirror (M1,M2) for sending a current (Iref1) which passes through the resistive means (Rext) to the capacitive means (C) comprising a first transistor (M1) having a first terminal linked to the programming terminal (103), a second terminal and having a control terminal linked to the first terminal of the first transistor (M1), and a second transistor (M2) having a first terminal linked to the capacitive means (C), a second terminal and a control terminal which are linked, respectively, to the second terminal and to the control terminal of the first transistor (M1),

    **characterized in that** said resistive means (Rext) are external and **in that** the integrated device further comprises filtering switch means (Sf) linked between the control terminal of the first transistor (M1) and the control terminal of the second transistor (M2), filtering means (Cf) linked between the control terminal and the second terminal of the second transistor (M2), and filtering control means (320) for maintaining the filtering switch means (Sf) in an open condition for a filtering time interval during the non-stable state of the circuit (300).

2. Integrated device (202) according to Claim 1, in which the integrated device (202) is able to be linked to an external power supply having a first (0V) and a second (Vcc) power terminal, and in which the resistive means comprise an external resistor (Rext) able to be linked between the programming terminal (103) and the first power terminal (0V), the capacitive means comprise a capacitor (C) having a first terminal linked to the first input terminal (+) of the comparator (120) and a second terminal able to be linked to the first (0V) or to the second (Vcc) power terminal, and the control means comprise a switch (SW) having a first terminal linked to the first input terminal (+) of the comparator (120) and a second terminal able to be linked to the first (0V) power terminal.

3. Integrated device (202) according to Claim 1 or 2, in which the filtering means (Cf) are capacitive filtering means.

4. Integrated device (202) according to Claim 2, in which the second terminal of the first transistor is able to be linked to the second power terminal (Vcc).

5. Integrated device (202) according to Claim 1, in which the first (M1) and second (M2) transistors are MOS type transistors, the control terminal being a gate terminal and the first and the second terminals being, respectively, a drain terminal and a source terminal.

6. Integrated device (302) according to Claim 1, in which the filtering interval begins with each switching of the circuit (300) to the non-stable state.

7. Integrated device (302) according to Claim 6, in which the filtering interval has a duration at least equal to the duration (Tc) of the non-stable state of the circuit (300).

8. Monostable circuit (200;300) comprising the integrated device (202,302) according to any one of Claims 1 to 7.

**Patentansprüche**

1. Integrierte Vorrichtung (202) für eine monostabile Schaltung (200), wobei die integrierte Vorrichtung (202) einen Programmieranschluss (103) aufweist, der mit einem Widerstandsmittel (Rext) verbunden werden kann, um die Dauer (Tc) eines nicht stabilen Zustands der Schaltung (200) zu programmieren, und mit:

einem Komparator (120) mit einem ersten (+) und einem zweiten (-) Eingangsanschluss und mit einem Ausgangsanschluss zum Erzeugen eines Ausgangssignals (Vout) der Schaltung (200), wobei der Programmieranschluss (103) mit dem zweiten Eingangsanschluss (-) des Komparators (102) verbunden ist, um daran eine Spannung (Vref1) anzulegen, die mit der Spannung an dem Widerstandsmittel (Rext) korreliert,
einem Kapazitäts-Mittel (C), das mit dem ersten Eingangsanschluss (+) des Komparators (120) verbunden ist, um eine Spannung (Vc) daran anzulegen, die mit der Spannung an den Kapazitäts-Mitteln (C) korreliert,
einem Steuermittel (SW, 115), das mit dem ersten Eingangsanschluss (+) des Komparators (120) verbunden ist, um die Schaltung (200) in den nicht stabilen Zustand zu schalten,
einem Stromspiegel (M1, M2) zum Senden eines Stroms (Irefl), der durch das Widerstandsmittel (Rext) zu dem Kapazitäts-Mittel (C) läuft, mit einem ersten Transistor (M1), der einen ersten mit dem Programmieranschluss (103) verbundenen Anschluss, einen zweiten Anschluss und einen mit dem ersten Anschluss des ersten Transistors (M1) verbundenen Steueranschluss aufweist, und einem zweiten Transistor (M2) mit einem mit dem Kapazitäts-Mittel (C) verbundenen ersten Anschluss, einem zweiten Anschluss und einem Steueranschluss, der mit dem zweiten Anschluss bzw. dem Steueranschluss des ersten Transistors (M1) verbunden ist,

**dadurch gekennzeichnet, dass** das Widerstandsmittel (Rext) extern ist, und dass die integrierte Vorrichtung ferner aufweist ein Filterschaltmittel (Sf), das zwischen dem Steueranschluss des ersten Transistors (M1) und dem Steueranschluss des zweiten Transistors (M2) geschaltet ist, ein Filtermittel (Cf), das zwischen dem Steueranschluss und dem zweiten Anschluss des zweiten Transistors (M2) geschaltet ist, und ein Filtersteuermittel (320) zum Halten des Filterschaltmittels (Sf) in einem offenen Zustand für ein Filterzeitintervall während des nicht stabilen Zustands der Schaltung (300).

2. Integrierte Vorrichtung (202) gemäß Anspruch 1, bei der die integrierte Vorrichtung (202) mit einer externen Leistungsversorgung verbunden werden kann, die einen ersten (0V) und einen zweiten (Vcc) Leistungsanschluss aufweist, und bei der das Widerstandsmittel einen externen Widerstand (Rext) umfasst, der zwischen dem Programmieranschluss (103) und dem ersten Leistungsanschluss (0V) geschaltet werden kann, wobei das Kapazitäts-Mittel einen Kondensator (C) mit einem ersten Anschluss, der mit dem ersten Eingangsanschluss (+) des Komparators (120) verbunden ist, und einen zweiten Anschluss, der mit dem ersten (0V) oder dem zweiten (Vcc) Leistungsanschluss verbunden werden kann, umfasst, und das Steuermittel einen Schalter (Sw) mit einem mit dem ersten Eingangsanschluss (+) des Komparators (120) verbundenen ersten Anschluss und einen zweiten Anschluss, der mit dem ersten (0V) Leistungsanschluss verbunden werden kann, umfasst.

3. Integrierte Vorrichtung (202) gemäß Anspruch 1 oder 2, bei der das Filtermittel (Cf) ein kapazitives Filtermittel ist.

4. Integrierte Vorrichtung (202) gemäß Anspruch 2, bei der der zweite Anschluss des ersten Transistors mit dem zweiten Leistungsanschluss (Vcc) verbunden werden kann.

5. Integrierte Vorrichtung (202) gemäß Anspruch 1, bei der die ersten (M1) und zweiten (M2) Transistoren vom MOS-Typ sind, wobei der Steueranschluss ein Gate-Anschluss ist, und wobei die ersten und die zweiten Anschlüsse jeweils ein Drain-Anschluss bzw. ein Source-Anschluss sind.

6. Integrierte Vorrichtung (302) gemäß Anspruch 1, bei der das Filterintervall mit jedem Schalten der Schaltung (300) in den nicht stabilen Zustand beginnt.

7. Integrierte Vorrichtung (302) gemäß Anspruch 6, bei der das Filterintervall eine Dauer mindestens gleich der Dauer (Tc) des nicht stabilen Zustands der Schaltung (300) aufweist.

8. Monostabile Schaltung (200;300), die die integrierte Vorrichtung (202, 302) gemäß einem der Ansprüche 1 bis 7 umfasst.


**Revendications**

1. Dispositif intégré (202) destiné à être utilisé dans un circuit monostable (200), le dispositif intégré (202) comportant une borne de programmation (103) susceptible d'être reliée à des moyens résistifs (Rext) de façon à programmer la durée (Tc) d'un état non stable du circuit (200), et comprenant :

   un comparateur (120) comportant une première (+) et une deuxième (-) borne d'entrée et une borne de sortie pour générer un signal de sortie (Vout) du circuit (200), la borne de programmation (103) étant reliée à la deuxième borne d'entrée (-) du comparateur (120) de façon à appliquer à celle-ci une tension (Vref1) corrélée à la tension sur les moyens résistifs (Rext),
   des moyens capacitifs (C) reliés à la première borne d'entrée (+) du comparateur (120) de façon à appliquer à celle-ci une tension (Vc) corrélée à la tension sur les moyens capacitifs (C),
   des moyens de commande (SW, 115) reliés à la première borne d'entrée (+) du comparateur (120) de façon à commuter le circuit (200) dans l'état non stable,
   un miroir de courant (M1, M2) pour envoyer un courant (Iref1) qui traverse les moyens résistifs (Rext) aux moyens capacitifs (C), comprenant un premier transistor (M1) comportant une première borne reliée à la borne de programmation (103), une deuxième borne, et comportant une borne de commande reliée à la première borne du premier transistor (M1), et un deuxième transistor (M2) comportant une première borne reliée aux moyens capacitifs (C), une deuxième borne et une borne de commande qui sont reliées, respectivement, à la deuxième borne et à la borne de commande du premier transistor (M1),

   **caractérisé en ce que** lesdits moyens résistifs (Rext) sont extérieurs, et **en ce que** le dispositif intégré comprend de plus des moyens de commutation de filtrage (Sf) reliés entre la borne de commande du premier transistor (M1) et la borne de commande du deuxième transistor (M2), des moyens de filtrage (Cf) reliés entre la borne de commande et la deuxième borne du deuxième transistor (M2), et des moyens de commande de filtrage (320) pour maintenir les moyens de commutation de filtrage (Sf) dans une condition ouverte pendant un intervalle de temps de filtrage durant l'état non stable du circuit (300).

2. Dispositif intégré (202) selon la revendication 1, dans lequel le dispositif intégré (202) est susceptible d'être relié à une alimentation extérieure comportant une première (0 V) et une deuxième (Vcc) bornes d'alimentation, et dans lequel les moyens résistifs comprennent une résistance extérieure (Rext) susceptible d'être reliée entre la borne de programmation (103) et la première borne d'alimentation (0 V), les moyens capacitifs comprennent un condensateur (C) comportant une première borne reliée à la première borne d'entrée (+) du comparateur (120) et une deuxième borne susceptible d'être reliée à la première (0 V) ou à la deuxième (Vcc) bornes d'alimentation, et les moyens de commande comprennent un commutateur (SW) comportant une première borne reliée à la première borne d'entrée (+) du comparateur (120) et une deuxième borne susceptible d'être reliée à la première (0 V) borne d'alimentation.

3. Dispositif intégré (202) selon la revendication 1 ou 2, dans lequel les moyens de filtrage (Cf) sont des moyens de filtrage capacitifs.

4. Dispositif intégré (202) selon la revendication 2, dans lequel la deuxième borne du premier transistor est susceptible d'être reliée à la deuxième borne d'alimentation (Vcc).

5. Dispositif intégré (202) selon la revendication 1, dans lequel les premier (M1) et deuxième (M2) transistors sont des transistors du type métal-oxyde-semi-conducteur (MOS), la borne de commande étant une borne de grille et les première et deuxième bornes étant, respectivement, une borne de drain et une borne de source.

6. Dispositif intégré (302) selon la revendication 1, dans lequel l'intervalle de filtrage commence avec chaque commutation du circuit (300) à l'état non stable.

**7.** Dispositif intégré (302) selon la revendication 6, dans lequel l'intervalle de filtrage a une durée au moins égale à la durée (Tc) de l'état non stable du circuit (300).

**8.** Circuit monostable (200 ; 300) comprenant le dispositif intégré (202, 302) selon l'une quelconque des revendications 1 à 7.

FIG.1

FIG.2a

FIG.2b

FIG.3